(19) Europäisches Patentamt
European Patent Office
Office européen des brevets

(11) Publication number: 0 366 190 A1

# (12) EUROPEAN PATENT APPLICATION

(21) Application number: 89202640.2

(51) Int. Cl.5: C08F 222/40

(22) Date of filing: 19.10.89

(30) Priority: 22.10.88 NL 8802605

(43) Date of publication of application:
02.05.90 Bulletin 90/18

(84) Designated Contracting States:
AT BE CH DE ES FR GB GR IT LI NL SE

(71) Applicant: STAMICARBON B.V.
Mijnweg 1
NL-6167 AC Geleen(NL)

(72) Inventor: Boulonnais, Daniel
18 Boulevard Victor Hugo
F-78100 St. Germain-en-Laye(FR)
Inventor: Brouwer, Hendrik Rogier
Geulhemmerweg 5A
NL-6325 PH Valkenburg a/d Geul(NL)
Inventor: Essers, Franciscus Elisabeth Jacobus
Bilserbaan 31
NL-6217 JD Maastricht(NL)

## (54) Bismaleimide compositions.

(57) The invention relates to a homogeneous, curable composition containing a first component consisting of a resin containing bismaleimide compounds, and a second component chosen from the group formed by polymers, oligomers and polymerizable monomers, and is characterized in that the second component contains at least a phosphate ester of hydroxyethyl (meth)acrylate. By application of such a phosphate ester the flammability of compositions containing bismaleimide compounds can be kept low while flammable substances are used in them. The composition is particularly suitable for the manufacture of fibre-reinforced laminates and sandwich panels.

EP 0 366 190 A1

# BISMALEIMIDE COMPOSITIONS

The invention relates to a homogeneous, curable composition containing a first component consisting of a resin containing bismaleimide compounds, and a second component chosen from the group formed by polymers, oligomers and polymerizable monomers, and further relates to the polymers and objects obtained with these compositions and by curing thereof.

It is known to apply bismaleimide compounds as bifunctional monomer or comonomer in compositions that are cured thermally by an addition reaction or via radicals. EP-A-206383 discloses a composition containing bismaleimide compounds. The polymers prepared thereof and objects made of these polymers have excellent properties such as, for instance, a high HDT (heat distortion temperature).

The bismaleimide compounds mentioned in EP-A-206383 can be polymerized both with and without comonomer. As comonomer use can be made of a vinyl compound, for example styrene or a hydroxyalkyl (meth)acrylate. Other components that can be applied in the mixtures containing bismaleimide are thermoplastics, rubbers or elastomers.

NL-A-8501660 discloses compositions containing bismaleimide and maleimide-amide compounds into which low-molecular polymers acting as flexibilizer are homogeneously incorporated.

EP-B-108461 discloses a composition into which bismaleimide compounds and styrene can homogeneously be incorporated by the addition of an acid compound.

The disadvantage of the compositions disclosed in the patent publication referred to is that the flammability is increased by the use of flammable flexibilizers or other substances in the bismaleimide compounds which in themselves are practically non-flammable.

The object of the invention is to provide compositions containing bismaleimide compounds that do not have the above-mentioned disadvantage.

This is achieved in that the second component contains at least a phosphate ester of hydroxyethyl (meth)acrylate.

It has, surprisingly, been found that a composition according to the invention has a strongly reduced flammability. The phosphate ester of hydroxypropyl (meth)acrylate, for instance, appears to lack a similar flammability-reducing effect.

The phosphate ester of hydroxyethyl (meth)acrylate (HEMA) will be denoted by PEMA. Under the right conditions PEMA polymerises with styrene and/or bismaleimide compounds and other monomers or polymers via an addition reaction.

The first component is a resin containing bismaleimide compounds. It is possible to use (virtually) pure bismaleimides, as is disclosed in EP-A-135.964, US-A-4.298.720 and US-A-4.224.427. The bismaleimides are represented by formula I

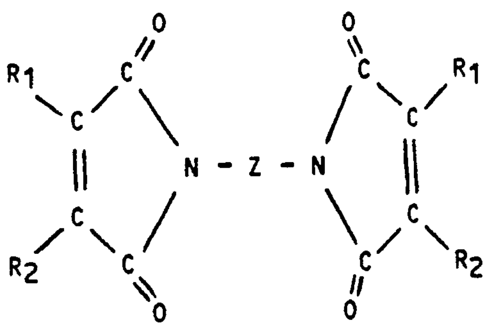

(I)

or an isomer thereof,

where $R_1$ and $R_2$ each and independently represent a hydrogen atom, an aliphatic, cycloaliphatic, aromatic group or a halogen-, hydroxy-, or nitro-substituted aromatic group with 1-12 carbon atoms, or a halogen atom, or where $R_1$ and $R_2$, together with the carbon atoms to which they are bound, form a ring system with at least one polymerizable C=C bond, where $R_1$, $R_2$, $R_3$ and $R_4$ may be identical or different, and Z represents an optionally halogen-, hydroxy- or nitro-substituted or non-substituted alkylene group containing 2-25 carbon atoms, or an optionally substituted meta-or paraphenylene group, or an optionally halogen- or nitro-substituted group of formula II:

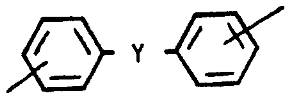 (II)

where Y represents a $-CH_2-$, a $-C(CH_3)_2$, an -O- or an $-SO_2-$ group.

It is, however, also possible to use mixtures in which monomaleimide compounds and maleic anhydride, among others, are present besides bismaleimide compounds, by preference a mixture containing bismaleimide compounds as described in EP-A-135.964.

The second component may, besides PEMA, also contain other polymers, oligomers or polymerizable monomers. They can be present in the composition for various reasons, for instance to reduce the viscosity or the melting point, to increase the impact strength of the final product, or to improve the compatibility of the ingredients.

As viscosity-reducing compound for instance a bismaleimide oligomer may be used, or for instance an ethylenically unsaturated monomer with fewer than 30 carbon atoms. As ethylenically unsaturated monomer a monomaleimide compound of an aromatic or aliphatic mono- or diamine may be used. These are described in, for instance, EP-A-135964, DE-A-3012179, FR-A-2031538 and US-A-4593038.

Furthermore vinyl aromatic compounds, alkyl (meth)acrylate, hydroxyalkyl (meth)acrylate, divinyl and di- and triallyl compounds are eligible as ethylenically unsaturated monomer. Examples are styrene, α-methyl styrene, p-methyl styrene, chlorostyrene, hydroxy-or aminoalkylstyrene, hexyl (meth)acrylate, ethyl (meth)acrylate, hydroxyethyl (meth)acrylate, divinyl benzene, vinyl toluene, diallyl cyanurate, triallyl isocyanurate, triallyl cyanurate, the divinyl ester of maleic acid, trimethylol propane triacrylate, etc.

Other monomers that can be used are maleic anhydride and unsaturated epoxy compounds, as for instance described in DE-A-235881.

It is preferred to use mixtures of ethylenically unsaturated monomers, more in particular a mixture of a monomaleimide compound and one or more other unsaturated monomers.

As impact modifiers vinyl-, amino- or carboxy-terminated rubber can for instance be added to the mixture described in the above. Examples of rubber types that can be used are described in EP-A-206383 and WO-A-8402528. Flexible polyester resins may also be used, and further all possible oligomers or thermoplastics. This may, however, raise the viscosity of the resin mixture to some degree.

If necessary, compounds can be added that increase the solubility of the bismaleimide in the monomers and oligomers, as described for instance in EP-B-108461.

By preference the components are applied in a proportion of 50-80 wt.% of the resin containing bismaleimide compounds and 20-50 wt.% of the second component. The second component preferably consists of 5-30 wt.% (relative to the total) PEMA, 0-15 wt.% of a vinyl aromatic monomer and less than 25 wt.% of a rubber.

Most preferably use is made of a composition with 60-75 wt.% resin containing bismaleimide compounds, 10-30 wt.% PEMA, 0-5 wt.% vinyl aromatic compound and 5-20 wt.% rubber.

The polymerization can be started by means of a radical initiator. Depending on the temperature and the amount of initiator, a gelling time between 80 and 1 min. can be achieved. As radical initiator any peroxide initiator may be used.

If desired, one or more customary additives such as inhibitors, fillers, reinforcing agents, pigments and curing catalysts may be added.

As fillers all conventional fillers are eligible, such as, for instance, carbon black, graphite, sand, lime, metal powder and metal oxides.

Instead of, or in combination with, fillers use is preferably made also of reinforcement fibres; as such for instance glass, carbon, aramide, ceramic and steel fibres are extremely suitable. The fibres are preferably used in an amount of 20-70 wt.%, as fibre sections of 0.1-5 cm long, as fibre tissues or as fibre bundles.

The polymers or objects obtained by curing of compositions according to the invention are characterized by low brittleness, with good chemical, physical and thermal properties, and a high degree of non-flammability. When burning or smouldering they have a low smoke density and a low toxic gas emission.

The compositions obtained according to the invention are highly suitable for fibre-reinforced composite materials, for instance for the manufacture of laminates and sandwich panels for use in the aeroplane industry, where materials with a high bending and tensile strength must also have a high degree of non-flammability.

Another application, for instance, is in printed circuit boards.

The invention will be elucidated on the basis of the following examples, without being restricted to the embodiments described therein.

Examples I through VII

In a Werner Pfleiderer Z-shaped blade kneader an amount of phosphate ester of hydroxyethyl methacrylate was mixed into a homogeneous mass with an amount of styrene and an amount of vinyl-terminated butadiene rubber (VTBN)(Goodrich Hycar 1300 x 22$^R$), the temperature being 60¤C.

The resin containing bismaleimide compounds was prepared in the following way:
At room temperature a solution of 100 g 4,4′-diaminodiphenyl methane in 300 ml acetone was added dropwise to 100 g maleic anhydride dissolved in 700 ml acetone. A quantitative precipitate of the corresponding dimaleimidic acid was formed. At 60¤C 150 g acetic anhydride and 1.5 g DABCO (1,4-diaza-bicyclo-(2,2,2)-octane) was added; the anhydride serves as water extraction agent and the amine as catalyst. The end of the reaction was characterized by complete disappearance of the diamido-acid precipitate. After removal under vacuum (0.1 mm Hg) of the solvent, acetic acid and acetic anhydride at 50-100¤C, a mixture in quantitative yield consisting of approximately 70% N,N′,4,4′-diphenylmethane-bis-maleimide, 25% 4-acetylaminophenyl-4′-maleimidophenyl-methane and approximately 5% maleic anhydride was obtained.

This powdery resin containing bismaleimide was added to the mass in the kneader, and kneading took place until a homogeneous mass was formed. The mass ratios are given below in Table 1. As initiator, 1 pph Trigonox C$^R$ from AKZO was added.

From the resin thus formed a glassfibre-reinforced prepreg was prepared with 40 to 50 mass % resin using a hot melt system (temperature between 60 and 80¤C). From this prepreg a laminate was prepared in a Scholz autoclave (1 hour's curing at 150¤C), and this laminate was used for testing purposes.

Example VIII

In a similar way to examples I through VII a laminate was prepared with an unsaturated polyester resin, Synoliet$^R$ 9550 from DSM, instead of the VTBN rubber.

Example IX

In a similar way to examples I through VII a laminate was prepared with 24.3 mass % VTBN rubber.

Comparative examples A through D

In a similar way to examples 1 through VII laminates were prepared with HEMA instead of PEMA, without the VTBN rubber.

Table 1 gives the formulations as applied in examples I through IX and comparative examples A through D

TABLE 1

| (Formulations) | | | | | | | |
|---|---|---|---|---|---|---|---|
| Ex. | BMI resin [mass%] | HEMA [mass%] | PEMA [mass%] | VTBN [mass%] | SYN 9550[R] [mass%] | STYRENE [mass%] | Initiator [pph] |
| I | 68.5 | | 14 | 17.5 | | | 1 |
| II | 72 | | 18 | 10 | | | 1 |
| III | 60 | | 20 | 10 | | 10 | 1 |
| IV | 60 | | 40 | | | | 1 |
| V | 55 | | 30 | 10 | | 5 | 1 |
| VI | 57.75 | | 31.5 | 10.5 | | 0.25 | 1 |
| VII | 60 | | 30 | 10 | | | 1 |
| VIII | 65 | | 24 | | 10 | 1 | 1 |
| IX | 60.5 | | 10.5 | 28.0 | | | 1 |
| A* | 45 | 12.75 | | | | 41.25 | 1 |
| B* | 55 | 11.25 | | | | 33.75 | 1 |
| C* | 60 | 10 | | | | 30 | 1 |
| D* | 65 | 8.75 | | | | 26.25 | 1 |

* comparative examples

The laminates produced were subjected to flame time tests according to UL-94 and Airbus Technical Specification 1000.001 (Far 25.853 (a)). The results are shown in Table 2. This ATS test is more demanding than the UL-94 test. Laminates tested according to Far 25.853 (a)(examples I through VIII) were found to have a flame time that is below the ATS norm (except example III), while the comparative examples A through D far exceed the UL-94 norm. This proves that replacement of HEMA by PEMA results in a reduction of flammability. Examples III and IX do not meet the limit values of the ATS norm and the UL-94 norm, respectively. Still, the flame time of the laminates according to these examples is quite a bit shorter than the flame time of the laminates from comparative examples A-D.

TABLE 2

| (average flame time) | | |
|---|---|---|
| Example | Flame time Far 25.853 [s] | Flame time UL-94 per flame contact [s] |
| I<br>II<br>III<br>IV<br>V<br>VI<br>VII<br>VIII | 0<br>0<br>23<br>0.2<br>2<br>0.2<br>14<br>3 | |
| IX<br>A<br>B<br>C<br>D | | 30*<br>> 60*<br>102*<br>90*<br>95* |
| Far 25.853 (a) | | |
| limit value | 15 | |
| UL-94 | | |
| $V_0$ norm<br>$V_1$ norm | | < 10<br>< 30 |
| Test I through VIII were carried out in accordance with Far 25.853 (a), ATS 1000.001, issue 4, paragraph 4.1, and tests IX through D in accordance with UL-94.<br>Flame time values are averages of 5 observations, the figures marked with * being averages of 10 successive flame contacts. | | |

The laminates according to examples VII and VIII were subsequently subjected to the other tests according to Airbus Technical Specification 1000.001. The results are presented in Table 3. They show that the product according to the invention amply meets these norms.

The product also satisfies the Smoke Emission Test (ATS 1000.001, issue 4, 8.1.2.2) and the Toxic Gas Emission Test (ib., § 8.1.2).

TABLE 3

| (Flammability) | | | |
|---|---|---|---|
| Example | Vertical test | | Flame time of drippings [s] |
| | Burn length [mm] | Flame time [s] | |
| VII | 49 | 14 | 0 |
| VIII | 34 | 3 | 0 |
| limit | 152 | 15 | 3 |
| The tests were carried out in accordance with Far 25.853 (a), ATS 1000.001, issue 4, paragraph 4.1. | | | |

## Claims

1. Homogeneous, curable composition containing a first component consisting of a resin containing bismaleimide compounds, and a second component chosen from the group formed by polymers, oligomers and polymerizable monomers, characterized in that the second component contains at least a phosphate ester of hydroxyethyl (meth)acrylate.

2. Composition according to claim 1, characterized in that use is made of 50-80 wt.% of resin containing bismaleimide compounds and 20-50 wt.% of a second component chosen from the group formed by polymers, oligomers and polymerizable monomers, with a phosphate ester of hydroxyethyl (meth)acrylate being applied in an amount of at least 5 wt.% relative to the total.

3. Composition according to any one of claims 1-2, characterized in that the composition comprises:
- 50-80 wt.% resin containing bismaleimides and
- 20-50 wt.% of the second component, which comprises:
- 5-30 wt.%, relative to the total, of phosphate ester of hydroxyethyl (meth)acrylate
- 0-15 wt.% vinylaromatically unsaturated monomers, alkyl (meth)acrylate, hydroxyalkyl (meth)acrylate, divinyl or di- and/or triallyl compounds,
- 0-25 wt.% rubber.

4. Composition according to any one of claims 1-3, characterized in that the composition comprises:
- 60-75 wt.% resin containing bismaleimides,
- 10-30 wt.% phosphate ester of hydroxyethyl (meth)acrylate,
- 0-5 wt.% vinylaromatically unsaturated monomer, and
- 0-25 wt.% rubber.

5. Polymer, obtained by curing a curable composition according to any one of claims 1-4.

6. Cured or not cured composite, comprising 40-90 wt.% composition according to any one of claims 1-4 and 10-60 wt.% fibrous material.

7. Object obtained by application of a composition, polymer or composite according to any one of claims 1-6.

8. Application of the phosphate ester of hydroxyethyl (meth)acrylate in compositions that contain bismaleimide.

9. Composition as essentially described in the specification and the examples.

European Patent Office

# EUROPEAN SEARCH REPORT

Application Number

EP 89 20 2640

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | EP-A-0 206 383 (DSM) | | C 08 F 222/40 |
| A | GB-A-2 021 597 (RHONE-POULENG) | | |
| A | US-A-4 444 969 (U. E. YOUNES) | | |
| | | | TECHNICAL FIELDS SEARCHED (Int. Cl.5) |
| | | | C 08 F |

The present search report has been drawn up for all claims

| Place of search | Date of completion of the search | Examiner |
|---|---|---|
| THE HAGUE | 30-01-1990 | CAUWENBERG C.L.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document